# EUROPÄISCHE PATENTSCHRIFT

(11) **EP 1 309 740 B1**
(45) Veröffentlichungstag und Bekanntmachung des Hinweises auf die Patenterteilung: **06.10.2004**
(21) Anmeldenummer: 01940178.5
(22) Anmeldetag: 11.04.2001
(51) Int. Cl.: C25D 1/00

(54) **ELASTISCHES KONTAKTELEMENT**
ELASTIC CONTACT ELEMENT
ELEMENT DE CONTACT ELASTIQUE

(30) Priorität: 20.04.2000 DE 10019713
(43) Veröffentlichungstag der Anmeldung: 14.05.2003
(73) Patentinhaber: ATOTECH Deutschland GmbH, 10553 Berlin (DE)
(72) Erfinder: HÜBEL, Egon, 90537 Feucht (DE)
(74) Vertreter: Bressel, Burkhard, Dr.
(86) Internationale Anmeldenummer: PCT/DE2001/001512
(87) Internationale Veröffentlichungsnummer: WO 2001/081657

(56) Entgegenhaltungen:
- WO-A-92/18669
- DE-A- 4 324 330
- US-A- 2 342 811
- PATENT ABSTRACTS OF JAPAN vol. 018, no. 215 (C-1191), 18. April 1994 (1994-04-18) -& JP 06 010186 A (KAWASAKI STEEL CORP), 18. Januar 1994 (1994-01-18)
- PATENT ABSTRACTS OF JAPAN vol. 005, no. 085 (C-057), 3. Juni 1981 (1981-06-03) & JP 56 029695 A (YOSHIDA KOGYO KK), 25. März 1981 (1981-03-25)
- PATENT ABSTRACTS OF JAPAN vol. 018, no. 615 (C-1277), 24. November 1994 (1994-11-24) & JP 06 235089 A (FUJI PHOTO FILM CO LTD), 23. August 1994 (1994-08-23)

## Beschreibung

Die vorliegende Erfindung bezieht sich auf die elektrische Kontaktierung von flachem Behandlungsgut bei der Durchführung elektrolytischer Prozesse in Durchlaufbehandlungsanlagen, vorzugsweise zur Behandlung von Leiterplatten und Leiterfolien. Insbesondere betrifft die Erfindung eine Durchlaufanlage mit einem Rotationselement zur elektrischen Kontaktierung von elektrolytisch zu behandelndem Gut, eine Anordnung von mindestens zwei Rotationselementen zur elektrischen Kontaktierung des Behandlungsgutes sowie ein Verfahren zur elektrischen Kontaktierung des Behandlungsgutes. Die Erfindung bezieht sich sowohl auf das Galvanisieren als auch auf das elektrolytische Ätzen.

Zur Herstellung von Leiterplatten werden elektrolytische Verfahren eingesetzt. Insbesondere wird Metall, vor allem Kupfer, abgeschieden, um die Leiterbahnen und Löt- sowie Bondplätze zu bilden. Im allgemeinen wird von beidseitig mit Kupferschichten überzogenem, dielektrischem Platten- oder Folienmaterial ausgegangen. Nach dem Herstellen von Durchgangsbohrungen durch das Material wird eine Kupferschicht vollflächig auf die Oberflächen, beispielsweise in einer Dicke von 30 µm, aufgebracht, wobei auch eine Kupferschicht auf den Bohrungswänden abgeschieden wird. Um Leiterzüge und andere Metallstrukturen bilden zu können, wird in einer Verfahrensvariante zunächst eine strukturierte Maske auf die Oberflächen der Platten bzw. Folien aufgetragen, wobei die Oberflächenbereiche freigelassen werden, in denen die Strukturen gebildet werden sollen. Hierzu wird das Leiterbild negativ aufgedruckt. Dies geschieht durch Siebdruck und bei der Feinleitertechnik durch phototechnische Verfahren (Photoresist). Eine Photoresistschicht weist üblicherweise eine Dicke von 25 µm bis zu 40 µm auf und stellt einen hochwertigen elektrischen Isolator dar. Auf dem Resist darf sich beim Leiterbildaufbau kein Metall abscheiden. In den freigelassenen Bereichen der Abdeckmaske wird anschließend Metall abgeschieden und das von der Abdeckmaske bedeckte Metall nach deren Entfernung schließlich abgeätzt. Dieses Verfahren wird als Pattern-Plating-Verfahren oder Leiterbildaufbau-Verfahren bezeichnet.

Zur elektrolytischen Behandlung muß eine elektrolytisch zu behandelnde leitfähige Oberfläche mit der hierfür nötigen Stromquelle elektrisch verbunden werden. Beim Galvanisieren ist der Minuspol und beim Ätzen der Pluspol der Stromquelle mit dieser Oberfläche in Verbindung zu bringen, wobei der jeweilige Gegenpol mit einer Gegenelektrode elektrisch verbunden ist, die wie die zu behandelnde Oberfläche mit einer Behandlungsflüssigkeit in Kontakt steht. In Durchlaufbehandlungsanlagen der Leiterplattentechnik wird hierfür unter anderem eine Walzenkontaktierung angewendet. Das Behandlungsgut, die Leiterplatten, werden zum Beispiel in horizontaler Richtung mittels unterer und oberer angetriebener Walzen oder Rädchen durch die einzelnen naßchemischen Behandlungsstationen und Spülstationen transportiert. Die Walzen bestehen in der Regel aus einem gegen die eingesetzten Elektrolyte resistenten Werkstoff, wie beispielsweise PP (Polypropylen), PE (Polyethylen) oder PVC (Polyvinylchlorid). Zum Abquetschen von Flüssigkeiten und zum gleichzeitigen Transport werden Walzen mit einem offenporigen oder geschlossenporigen Schwammüberzug verwendet.

Zur elektrischen Kontaktierung der Leiterplattenoberflächen in elektrolytischen Behandlungsstationen werden metallische Kontaktwalzenpaare, das heißt obere und untere Walzen, verwendet. Diesen wird der Strom von der Badstromquelle beispielsweise über einen Schleifkontakt zugeführt. Die metallische Oberfläche jeder Walze rollt auf der Oberfläche der zu behandelnden Platten ab. Diese Walzen dienen zum Transport des Behandlungsgutes und zugleich zur Stromübertragung zu dessen Oberfläche.

In DE 36 03 856 A1 wird eine derartige Vorrichtung zum Galvanisieren von Leiterplatten beschrieben. Die Leiterplatten werden innerhalb der Galvanisieranlage von einem kathodisch geschalteten, rotierenden Walzenpaar erfaßt und transportiert. Die Walzen bestehen aus rostfreiem Edelstahl oder Titan.

In EP 0 959 153 A2 ist eine ähnliche Vorrichtung beschrieben: Metallwalzen sind beiderseits einer horizontalen Transportebene angeordnet. Die zu behandelnden Leiterplatten werden über diese Walzen elektrisch kontaktiert. Hierzu wird eine elektrische Verbindung von einer externen Stromquelle zu den Metallwalzen über eine rotierende Stromübertragungseinrichtung hergestellt.

In JP-A-63-297588, Patent Abstracts of Japan, ist ein elektrolytisches Verfahren zur Behandlung elektrisch isolierter Leiterstrukturen auf Leiterplatten offenbart. Zum Galvanisieren werden die mitunter sehr kleinen isolierten Flächen mittels einer metallischen, rotierenden Bürste elektrisch kontaktiert.

Mit den bekannten Vorrichtungen und Verfahren ist es nicht möglich, Metallschichten in gleichmäßiger Dicke abzuscheiden, ohne daß die Leiterplatten beschädigt werden. Es hat sich nämlich herausgestellt, daß insbesondere bei der elektrolytischen Behandlung großformatiger Platten Schichtdickenschwankungen auftreten und die Platten bei der Behandlung sogar beschädigt werden können. Auch bei der elektrolytischen Metallisierung von Leiterzugmustern beim Pattem-Plating-Verfahren ist festgestellt worden, daß die Schichtdicke der einzelnen Leiterbahnen innerhalb eines weiten Bereiches schwanken kann. Ursachen für diese Probleme und deren Behebung sind den genannten Dokumenten nicht zu entnehmen.

Der vorliegenden Erfindung liegt von daher das Problem zugrunde, die Nachteile der bekannten Verfahren zu vermeiden und insbesondere Maßnahmen zu finden, mit denen Leiterstrukturen auf Leiterplatten und Leiterfolien mit geringer Schichtdickenschwankung und ohne Beschädigung der Platten- und Folienoberflächen im Leiterbildaufbau-Verfahren hergestellt werden können. Insbesondere sollen auch großformatige Platten sowie feinste Leiterzüge problemlos und insbesondere ohne fehlerhafte Leiterstrukturen erzeugt werden können.

Das Problem wird gelöst durch die Durchlaufanlage gemäß Anspruch 1. Bevorzugte Ausführungsformen der Erfindung sind in den Unteransprüchen angegeben.

Die erfindungsgemäße Durchlaufanlage weist Rotationsmittel zur elektrischen Kontaktierung von elektrolytisch zu behandelndem, flachem Gut in der Durchlaufbehandiungsanlage auf. Derartige Anlagen werden häufig zur Herstellung von Leiterplatten und Leiterfolien eingesetzt. In erfindungsgemäßer Weise wird das Rotationselement an dessen auf dem Behandlungsgut abrollender Lauffläche zumindest teilweise mit einem elastischen, elektrisch leitfähigen Werkstoff versehen. Das Behandlungsgut wird dadurch zumindest teilweise über den elastischen, elektrisch leitfähigen Werkstoff elektrisch kontaktiert.

Das Rotationselement ist vorzugsweise als Kontaktwalze ausgebildet. Es kann aber auch als Kontaktrad oder als Kontaktspirale ausgebildet sein. Im letzteren Falle handelt es sich um eine an den Enden mit einem Antrieb verbundene und insbesondere freitragende Spirale, vorzugsweise aus Metall.

Werden Kontaktwalzen eingesetzt, so sind zumindest die Mantelflächen der Kontaktwalzen, die auf den Oberflächen des Behandlungsgutes abrollen, in einer ersten Ausführungsform zumindest überwiegend, vorzugsweise vollständig, das heißt partiell bzw. vollkommen mit dem elastischen, elektrisch leitfähigen Werkstoff überzogen.

Dieser Werkstoff entsteht durch Einlagerung eines elektrisch leitfähigen Füllstoffes, so daß er den elektrischen Strom sehr gut leitet. Damit sind derartige Kontaktwalzen überraschend gut geeignet, den zur elektrolytischen Behandlung erforderlichen hohen Strom zu übertragen. Gleichzeitig findet im Vergleich zu den metallischen Kontaktwalzen nach dem Stand der Technik eine sehr schonende Berührung der üblicherweise empfindlichen Leiterplattenoberflächen statt.

Wenn auch Bürsten zur Kontaktierung von elektrisch isolierten Leiterstrukturen auf dielektrischem Material grundsätzlich geeignet sind, um diese elektrolytisch zu behandeln, so stellt sich doch heraus, daß sich Metall beim Galvanisieren bevorzugt an den Bürsten niederschlägt urid die Borsten versteift. Dies führt zu Beschädigungen am Behandlungsgut. Daher ist die in JP-A-63-297588 beschriebene Vorrichtung nicht gut geeignet, um Leiterplatten und Leiterfolien herzustellen.

Die Kontaktbürste nach dem beschriebenen Stand der Technik eignet sich ferner nur für kleine Ströme, weil die Bürstenhaare sehr dünn und flexibel sein müssen. Wählt man größere Querschnitte der Haare zur Übertragung von höheren Strömen, so leidet die Oberflächenqualität durch Verkratzen. Des weiteren werden die Bäder durch abbrechende Bürstenhaare verunreinigt Diese Bürstenpartikel werden auch an der Oberseite der Leiterplatten in horizontalen Durchlaufbehandlungsanlagen angalvanisiert. Völliger Ausschuß ist die Folge.

Bei Verwendung der erfindungsgemäßen Durchlaufanlagen mit Rotationselementen mit elastischer, elektrisch leitfähiger Lauffläche werden die genannten Probleme vermieden. Insbesondere bestehen keine Beschränkungen hinsichtlich der anzuwendenden Stromdichte. Außerdem ist das Kontaktierelement ausreichend stabil gegen Abrieb, so daß die Behandlungsflüssigkeit dadurch kaum verunreinigt werden kann.

Um die Metallisierung der Kontaktierelemente selbst zu vermeiden, sind in DE 36 03 856 A1 und EP 0 959 153 A2 Ausführungsformen der dort beschriebenen Kontaktwalzen mit besonderen Abschirmmaßnahmen vorgesehen.

Die aus DE 36 03 856 A1 und EP 0 959 153 A2 bekannten metallischen Kontaktwalzen müssen allerdings sehr präzise gefertigt und in der Durchlaufbehandlungsanlage auch präzise gelagert sein, insbesondere wenn das Behandlungsgut dünn ist. Bei der Feinleitertechnik werden die zu verarbeitenden Folien immer dünner. Bei nicht präziser Fertigung, das heißt bei nicht fluchtenden Walzenachsen liegt nur ein Teil der unteren und oberen Walze auf den Folien mit der vorgesehenen Auflagekraft auf. Die weiteren Mantellinien der Walzen tragen nicht zur Stromübertragung bei. Andererseits sind dickere Leiterplatten, wie zum Beispiel Multilayer, niemals völlig plan. So ist zum Beispiel nach den internationalen Normen PERFAG 2D und IPC-TM-650 Number 2.4.22 eine maximale Wölbung von 1,0 % bei einer Plattendicke von 1,5 mm bis 3,2 mm zulässig. Bei einer Plattenausdehnung mit einer Kantenlänge von beispielsweise 400 mm beträgt die noch zulässige Wölbung damit 4 mm. Daher liegen die Kontaktwalzen auch bei dicken und stets sehr starren Platten nicht auf der gesamten Mantellinie auf. Stromübertragungsprobleme bis hin zur Beschädigung der Leiterplatten sind die Folge.

Auch diese Probleme werden mit der erfindungsgemäßen Durchlaufanlage vermieden. Insbesondere kann eine gleichmäßige Auflage der Kontaktelemente auf der zu metallisierenden Oberfläche erreicht werden.

Gänzlich ungeeignet sind die Walzenkontaktierungen mit starren Walzen beim Galvanisieren eines Leiterbildes auf Leiterplatten und Leiterfolien nach dem Pattern-Plating-Verfahren. Wegen der Dicke des isolierenden Lackes erreicht eine starre Kontaktwalze nicht die in den Vertiefungen befindlichen, zu galvanisierenden Metallschichten, die meist aus Kupfer bestehen. Daher kann das sich in den vom Photoresist gebildeten Vertiefungen befindende Kupfer elektrisch nicht kontaktiert werden. Somit ist ein elektrolytischer Leiterbildaufbau derartiger Leiterplatten mit diesen Kontaktwalzen unmöglich. Auch die in JP-A-63-297588 beschriebene Kontaktbürste ist zur elektrischen Kontaktierung wegen der oben beschriebenen Nachteile völlig ungeeignet. Hier kommt noch hinzu, daß der empfindliche Lack durch die Bürsten zerkratzt und Lackkanten beschädigt werden.

Die zu verwendende Shore-Härte des elastischen Werkstoffes auf dem Rotationselement nach DIN 53 505 richtet sich nach dem Anwendungsfall:

Beim vollflächigen elektrolytischen Bearbeiten von Leiterplatten und Leiterfolien kann der elastische Werkstoff härter eingestellt werden als beim elektrolytischen Leiterbildaufbau (Pattern-Plating-Verfahren), bei dem lediglich die in Vertiefungen in der Photoresistmaske liegenden Leiterstrukturen zu metallisieren sind. Die Elastizität wird zunächst zum Ausgleich von Leiterplattenwölbungen und verschieden dicken Bereichen des Behandlungsgutes und zum Ausgleich mechanischer Toleranzen der Walzenlagerung sowie ferner zum Schutz der Oberflächen gegen Beschädigungen, wie Kratzern, Druckstellen und Strombrandmarken benötigt.

Beim Leiterbildaufbau, insbesondere bei der Feinleitertechnik soll ein möglichst großer Anteil der kontaktgebenden Walzenmantellinie die zu Beginn der Behandlung um die Photoresistdicke tiefer liegende metallische Oberfläche erreichen, das heißt elektrisch kontaktieren. Hierfür ist eine größere Elastizität des kontaktgebenden Werkstoffes nötig, um den Höhenunterschied zu den Vertiefungen zu überbrücken. Es ist jedoch nicht erforderlich, daß die gesamte Mantellinie zu jeder Zeit, das heißt bei dem in der Durchlaufbehandlungsanlage durchfahrenden Leiterbild kontaktierend aufliegt. Auf jedem zu produzierenden Nutzen gibt es größere Kontaktflächen, wie beispielsweise die später abgetrennten Ränder. Diese sind sowohl an der Oberseite als auch an der Unterseite einer Leiterplatte vorhanden. Beide Seiten sind an den Rändern und durch die vielen durchkontaktierten Löcher miteinander elektrisch leitend verbunden.

Hinzu kommt, daß die zu galvanisierende Fläche beim Leiterbildaufbau immer kleiner ist als bei vollflächiger Behandlung. Entsprechend kleiner ist der über die Kontaktwalzen zu übertragende Strom, auch wenn mit der gleichen örtlichen Stromdichte gearbeitet werden sollte.

Mit fortschreitender Galvanisierzeit füllen sich die Leiterzüge in den Vertiefungen zwischen den Photoresistwänden auf. Damit werden diese Oberflächen auch von Kontaktwalzen erreicht, deren Oberflächen weniger elastisch sind. Alternativ kann bei gleicher Elastizität auch die Oberfläche von schmäleren Leiterzügen erreicht, das heißt kontaktiert, werden. Dies erlaubt auch den Einsatz mehrerer in Transportrichtung gesehen hintereinander angeordneter Rotationselemente in einer Durchlaufbehandlungsanlage, die an der Oberfläche unterschiedlich elastisch sind: In Transportrichtung können in einer Anlage Kontaktwalzen verwendet werden, deren Härte in Durchlaufrichtung zunimmt. Eine derartige Anordnung ist insofern vorteilhaft, als härtere Walzen etwas verschleißfester sind und somit insgesamt ein geringerer Abrieb erreicht wird. Als Richtwert für die Härte gilt ein Wert im Bereich von 2 bis 60 Shore A nach DIN 53 505.

Als elastische Kontaktwerkstoffe kommen Metall/Kunststoff-Verbundwerkstoffe, insbesondere aus einem elastischen Kunststoff mit einem hohen Anteil an elektrisch leitfähigen Füllstoffen gebildete Verbundwerkstoffe, in Frage. Sie bestehen aus Elastomeren wie Kautschuk, Silikon oder anderen elastischen Kunststoffen, die elektrochemisch beständig sind. Hierzu gehören auch nicht vollkommen aushärtende Leitklebstoffe, wie sie in der Elektronikfertigung Verwendung finden. Derartigen Werkstoffen wird bei der Herstellung ein elektrisch leitfähiger Füllstoff beigemischt. Dadurch entsteht ein Metall/Kunststoff-Verbundwerkstoff.

Die Füllstoffe, auch Einlagerungskomponenten genannt, bestehen für diesen Anwendungsfall bevorzugt aus Metall in Form von Pulvern, Fasern, Nadeln, Zylindern, Kugeln, Flocken, Filz und anderen Formen. Die Abmessungen dieser Füllstoffe liegen im Bereich von Nanometern bis zu etwa 100 Mikrometern. Die Faserlängen haben Durchmesser und Längen von einigen Nanometern bis zu einigen Millimetern. Der Anteil des Füllstoffes an dem gesamten Kontaktwerkstoff beträgt bis zu 90 Gewichtsprozent. Mit zunehmendem Füllstoffanteil nimmt die Elastizität des Metall/Kunststoff-Verbundes ab und die elektrische Leitfähigkeit zu. Beide Größen werden an den jeweiligen Anwendungsfall angepaßt. Als Füllstoffe eignen sich alle elektrochemisch beständigen Werkstoffe, die zugleich elektrisch leitfähig sind. Übliche Füllstoffe sind beispielsweise Titan, Niob, Platin, Gold, Silber, Edelstahl und Elektrokohle. Verwendbar sind zum Beispiel auch platinierte oder vergoldete Partikel, wie Kugeln aus Titan, Kupfer, Aluminium oder Glas.

Vorteilhaft bei der Herstellung eines Metall/Kunststoff-Verbundes ist ein leichter Werkstoff wie Glas, Aluminium oder Titan. Die erforderliche elektrische Leitfähigkeit der vergleichsweise leichten Partikel wird beispielsweise durch eine elektrolytische Beschichtung mit Platin, Gold oder Silber hergestellt. Bei nicht beschichteten Titan- oder Aluminiumpartikeln würde die Metalloxidation eine sehr gute elektrische Leitfähigkeit verhindern. Ganz besonders vorteilhaft sind metallische Hohlkugeln. Sie sind elektrisch gut leitend und von geringem Gewicht. Herstellbar sind Kugeln mit einem Durchmesser von 0,2 mm und weniger. Die Wandstärke ist wählbar. Sie liegt im Bereich beispielsweise von 10 Mikrometer. Hier liegt somit ein Füllstoff vor, der ein spezifisches Gewicht aufweist, das durch Wahl der Kugelabmessungen, insbesondere der Wandstärke der Kugeln, an das spezifische Gewicht des elastischen Werkstoffes exakt angepaßt werden kann. Somit findet bei der Herstellung des Metall/Kunststoff-Verbundes keine Entmischung statt. Der Verbund ist hervorragend homogen.

Die leichten Füllstoffe neigen bei der Herstellung des Metall/Kunststoff-Verbundes auch während des Aushärtens nicht zur Entmischung. Der Verbund bleibt sehr homogen, so daß die elektrische Leitfähigkeit immer ausreichend hoch ist. Gleich gute Ergebnisse werden mit Füllstoffpartikeln mit sehr kleinen Abmessungen erzielt, mit sogenannten nanostrukturierten Verbunden. Auch Metallfasern oder Metallflocken führen bei der Herstellung des elastischen und elektrisch leitfähigen Werkstoffes nur zu einer geringen Entmischung, das heißt zu einem homogenen Metall/Kunststoff-Verbund. Durch die Homogenität wird die Lebensdauer dieser elastischen, elektrischen Leiter verbessert. Der gesamte Leiterquerschnitt wird mit einer gleichen Stromdichte beaufschlagt. Örtliche Überhitzungen treten nicht auf.

Die mit diesen Füllstoffen erreichbare elektrische Leitfähigkeit des elastischen Kontaktwerkstoffes beträgt 10⁻³ Ωcm und in besonderen Fällen sogar 10⁻⁴ Ωcm. Dies stellt eine nur etwa zehnmal geringere Leitfähigkeit gegenüber der Leitfähigkeit der für elektrolytische Prozesse verwendbaren Metalle wie Titan dar.

Weil die elektrische Leitfähigkeit des elastischen Kontaktwerkstoffes etwa zehnmal geringer ist als die der gebräuchlichen Metalle, entsteht in diesem Werkstoff eine zusätzliche Verlustleistung. Deshalb wird die Dicke des Kontaktwalzenüberzuges klein gehalten, insbesondere wenn das Rotationselement zur elektrischen Kontaktierung von Behandlungsgut bei vollflächiger elektrolytischer Bearbeitung eingesetzt werden soll. Beispielsweise ist ein 3 mm dicker Kontaktwerkstoffüberzug auch für das Kontaktieren zum Leiterbildaufbau ausreichend.

Das Rotationselement kann als Kontaktwalze ausgebildet sein. In diesem Fall kann die Kontaktwalze einen elektrisch leitfähigen Kern aufweisen, dessen Oberfläche beispielsweise aus Metall, beispielsweise Edelstahl oder Titan, bestehen kann. Geeignet sind hierfür auch Metall/Kunststoff-Verbunde mit der erforderlichen Festigkeit und elektrischen Leitfähigkeit.

Vorteilhaft für die Kühlung ist die Rotation der Kontaktwalze. Dadurch können sich die erwärmten Kontaktbereiche während einer Umdrehung im Elektrolyten wieder abkühlen. Vorteilhaft ist es auch, daß der Kontakt nicht nur von einer exakten Mantellinie der Walze gebildet wird, wie es bei einer harten metallischen Walze nach dem Stand der Technik der Fall ist. Der elastische Kontaktwerkstoff bildet an der Berührungsstelle eine Fläche. Diese wird mit zunehmender Kontaktkraft und höherer Elastizität größer. Die örtlich wirkende Stromdichte nimmt dadurch deutlich ab. Durch diese Querschnittsvergrößerung an der jeweils wirkenden Kontaktstelle nimmt der elektrische Widerstand ab und damit auch die Verlustleistung, das heißt die Erwärmung.

Die Kontaktkraft wird in einer horizontalen Durchlaufbehandlungsanlage zum Beispiel durch eine Federkraft und/oder durch das Eigengewicht der oberen Kontaktwalzen gebildet. Eine darunter befindliche Walze nimmt die Gegenkraft auf. Daher ist eine Anordnung von mindestens zwei Rotationselementen mit elastischer, elektrisch leitfähiger Lauffläche vorteilhaft, bei der die Rotationselemente, beispielsweise Kontaktwalzen, in der Durchlaufbehandlungsanlage beiderseits der Transportebene angeordnet sind. Die obere Walze ist hierzu im Abstand zur unteren Walze frei beweglich gelagert. Sie paßt sich somit der Plattendicke und dem Grad des Einsinkens an der kontaktgebenden Mantellinie selbsttätig an. Die untere Kontaktwalze ist üblicherweise in der Höhe fest justiert.

Eine besonders einfache kostengünstige Ausführungsform einer Kontaktwalze ergibt sich, wenn der Grundkörper, das heißt deren elektrisch leitfähiger Kern, an der Mantelfläche lediglich mit elastischen und elektrisch leitfähigen Ringen oder Bändern versehen wird. Diese Ringe oder Bänder (Kontaktstreifen) können in Nuten/Rillen der Walze formschlüssig eingelegt sein, vorzugsweise ringförmig, so daß sie zwar dort arretiert, aber leicht austauschbar und an die jeweilige Aufgabenstellung anpaßbar sind. Die Kontaktstreifen ragen vorzugsweise über die Mantelfläche des Kems der Kontaktwalze hinaus.

Ist der elastische, elektrisch leitfähige Kontaktwerkstoff nur partiell auf dem Rotationselement aufgebracht (beispielsweise in einer spiralförmigen Nut), so ist es vorteilhaft, die nicht mit dem elastischen Kontaktwerkstoff belegten, elektrisch leitfähigen Flächen zu isolieren, zumindest soweit sie in die Behandlungsflüssigkeit eintauchen, damit an diesen Stellen kein Strom übertragen wird. Damit ist gewährleistet, daß kein elektrolytischer Metallauf- oder -abtrag an diesen Stellen stattfindet. Hierzu geeignet sind elektrisch nichtleitende Überzüge, insbesondere Kunststoffüberzüge, aus chemisch beständigem Material, beispielsweise HALAR ®, das auch zum Isolieren von Galvanisiergestellen verwendet wird. Das gleiche gilt für die Stirnflächen der Kontaktelemente, die nicht der Stromübertragung dienen, zumindest soweit sie in die Behandlungsflüssigkeit eintauchen.

Als Werkstoff für die Kontaktstreifen kommt wiederum ein Metall/Kunststoff-Verbund in Frage. In einer alternativen Ausführungsform eignet sich aber auch eine metallische Spiralfeder mit schrägliegenden Windungen, die zu einem Ring zusammengefügt ist. Anstelle der Ringe können die elastischen Werkstoffe auch spiralförmig auf der Walze aufgewickelt und an den Enden der Kontaktwalze befestigt sein. In allen Fällen verlaufen diese Ringe, Bänder und Federn in Rillen in der Mantelfläche des Kerns der Walze und ragen aus diesem heraus. Nur diese rollen auf dem Behandlungsgut ab.

Von der stationären Badstromquelle und damit vom feststehenden Teil der Durchlaufbehandlungsanlage wird elektrischer Strom zum Rotationselement, beispielsweise einer Kontaktwalze, mittels eines bekannten Schleifkontaktes. übertragen, der auf einer Schleifbahn der Walze anliegt.

Zur Stromversorgung des Rotationselements besteht auch die weitere Möglichkeit, einen rotierenden Kontakt (Drehkontakt) zu verwenden. Hierbei handelt es sich um ein dicht abgeschlossenes Gehäuse mit einer rotierenden Fläche und einer von dieser durch einen Spalt getrennten stationären Fläche. Der Spalt ist mit einem fließfähigen Stromübertragungsmittel, beispielsweise einer elektrisch gut leitfähigen Flüssigkeit, Suspension oder einem Metallpulver, gefüllt Die Suspension besteht aus aufgeschwämmtem Metallpulver, wie bei den Füllstoffen beschrieben. Dieser rotierende Kontakt ist verschleißfrei und bedarf keiner Wartung.

Die Rotationselemente mit elastischer, elektrisch leitfähiger Lauffläche können grundsätzlich ausschließlich zur elektrischen Kontaktierung des Behandlungsgutes eingesetzt werden. Es ist jedoch auch vorteilhaft, wenn die Rotationselemente auch zum Transport des Behandlungsgutes dienen und hierzu mit einem Antrieb versehen werden.

Falls die Bohrungen in Leiterplatten vor der weiteren Behandlung bereits mit einer elektrochemisch aufgebrachten Kupferschicht durchkontaktiert wurden, genügt für die weitere Verfahrensführung in der Leiterplattentechnik beispielsweise eine einseitige Anbringung von Kontaktwalzen mit gegenseitig angebrachten nichtleitenden Stützwalzen, da eine einseitige Kontaktierung unter diesen Bedingungen ausreichend ist:

Eine Walze auf der einen Seite der Transportebene ist zum Beispiel als Kontaktwalze ausgeführt, während die andere Walze nur dem Transport der Leiterplatten dient. Beim Transport des Behandlungsgutes in einer horizontalen Ebene kann beispielsweise die untere Walze als Kontaktwalze ausgeführt sein, während die obere Walze nur dem Transport der Leiterplatten dient oder umgekehrt. Hierzu kann beispielsweise die Kombination einer Kontaktwalze mit elastischer, elektrisch leitfähiger Lauffläche mit einer normalen Transportwalze (beispielsweise aus Kunststoff) bzw. mit einem normalen Transportrad entsprechend dem Stand der Technik gewählt werden. Durch die sehr homogene Stromeinleitung der einseitigen Kontaktwalzen, die mit dem elastischen und elektrisch leitenden Werkstoff überzogen sind, kann der Strom auch zur elektrolytischen Behandlung der Gegenseite mit eingeleitet werden. Die beiden Seiten der Leiterplatten sind über die leitfähige Schicht in den Löchern und über die Ränder ausreichend elektrisch miteinander verbunden. Mit zunehmender Schichtdicke während des Galvanisierens wird die elektrische Leitfähigkeit dieser elektrischen Verbindung zunehmend größer. Der Einsatz von Kunststoffwalzen zum Beispiel an der Oberseite anstelle von leitfähigen Kontaktwalzen spart erheblich an Kosten. Unter anderem ist eine Stromübertragung zur rotierenden und zusätzlich höhenbeweglichen Kontaktwalze unter diesen Bedingungen nämlich nicht notwendig.

Daher können die Rotationselemente mit elastischer, elektrisch leitfähiger Lauffläche sowohl beiderseits der Transportebene in der Durchlaufbehandlungsanlage eingesetzt werden, als auch jeweils nur oberhalb oder nur unterhalb der Transportebene oder auch abwechselnd oberhalb und unterhalb der Transportebene. Werden die Kontaktwalzen vorteilhafterweise nur einseitig, jedoch in Transportrichtung abwechselnd oben und unten eingebaut, so sind zumindest zeitweise auch die kürzesten Leiterplatten oben und unten elektrisch direkt über die Kontaktmittel mit der Badstromquelle elektrisch verbunden.

Der Abstand von Kontaktwalze zu Kontaktwalze in Transportrichtung wird so gewählt, daß die in Transportrichtung kürzeste Leiterplatte stets mit der Badstromquelle elektrisch verbunden bleibt. Das heißt auch, daß die kürzeste zu behandelnde Leiterplatte mit ihrer nachlaufenden Kante noch in elektrischem Kontakt mit der zurückliegenden Kontaktwalze steht, während die nächstfolgende Kontaktwalze bereits die vorlaufende Kante derselben Leiterplatte kontaktiert. Zwischen zwei Kontaktwalzen in Transportrichtung befinden sich die oberen und unteren Anoden der Durchlaufbehandlungsanlage.

In Durchlaufbehandlungsanlagen können die Kontaktwalzen auch außerhalb des Flüssigkeitsbades vor und hinter einer elektrolytischen Teilzelle oder zwischen zwei oder mehreren elektrolytischen Teilzellen und zusätzlich vor und hinter der ersten und der letzten dieser Teilzellen angeordnet sein, um eine elektrolytische Metallisierung der leitfähigen Kontaktwalzen sicher zu vermeiden. Ist dies nicht möglich, müssen die Kontaktwalzen belspielsweise von Zeit zu Zeit durch Umpolung entmetallisiert werden.

Zur näheren Erläuterung der Erfindung dienen die nachfolgend angegebenen Figuren. Es zeigen im einzelnen:

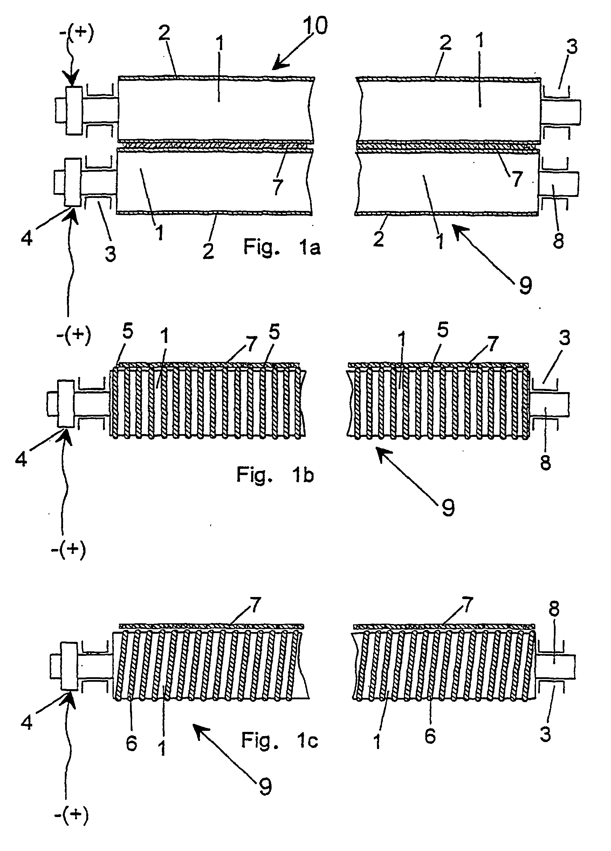

- **Fig. 1a:**: eine Kontaktwalze mit einem vollflächigen elastischen, elektrisch leitfähigen Überzug in Seitenansicht;
- **Fig. 1b:**: eine Kontaktwalze mit ringförmigen Kontaktstreifen in Seitenansicht;
- **Fig. 1c:**: eine Kontaktwalze mit spiralförmigem Kontaktstreifen in Seitenansicht.

In **Fig. 1a** bis **1c** sind die Galvanisierzelle mit dem Elektrolyt-Vorratsbehälter, den Pumpen, den Transportwalzen, entsprechenden löslichen oder unlöslichen Anoden, den Stromerzeugungs- und Stromzuführungs-Einrichtungen, den Elektrolyt-Zuführungsdüsen, sowie den Stauwalzen am Ein- und Auslauf des Behandlungsgutes nicht dargestellt.

In **Fig. 1a** sind die untere Kontaktwalze **9** und die obere Kontaktwalze **10,** bestehend aus Walzenkernen **1** aus einem elektrochemisch beständigen, elektrisch gut leitfähigen Werkstoff, wie zum Beispiel Metall (Titan, Edelstahl), dargestellt. Über die gesamte Mantelfläche erstreckt sich der elektrisch leitfähige, elastische Kontaktwerkstoff **2.** Er ist durch leitfähiges Vulkanisieren, Kleben oder mechanisches Befestigen wie Schrauben, Nieten oder Klemmen auf dem Kern **1** befestigt. Bei der mechanischen Befestigung ist darauf zu achten, daß die Elastizität des Überzugs an den Befestigungsstellen nicht wesentlich verändert wird. An beiden Enden der Kontaktwalzen **9,10** sind Lagerzapfen **8** mit den Lagern **3** angebracht. Mindestens an einem Ende der Kontaktwalzen **9,10** befinden sich die Stromzuführungen beispielsweise in Form von Schleifringen oder Schleifkontakten **4** oder eines hermetisch geschlossenen rotierenden Kontaktes mit einer elektrisch leit- und fließfähigen Füllung zur Stromübertragung.

In **Fig. 1b** ist eine untere Kontaktwalze **9** dargestellt. Deren Walzenkern **1** ist mit Rillen versehen, in die der ringförmige Kontaktwerkstoff **5** formschlüssig eingelegt ist. Bei der Auslegung der Ringe **5** muß die mechanische Spannung im eingelegen Zustand so hoch sein, daß die Reibhaftung der Ringe **5** ausreichend hoch ist, um das Behandlungsgut **7** ohne Schlupf transportieren zu können. Auch in diesem Falle sind wiederum der Lagerzapfen **8** der Kontaktwalze **9**, das Lager **3** sowie die Stromzuführung **4** dargestellt.

In **Fig. 1c** ist ebenfalls eine untere Kontaktwalze **9** dargestellt. Hier weist der Walzenkern **1** eine spiralförmige Nut auf, in die der elastische, leitfähige Kontaktwerkstoff **6** formschlüssig eingelegt ist. An beiden Enden der Kontaktwalze **9** sind in diesem Ausführungsbeispiel nicht dargestellte Befestigungselemente erforderlich, mit denen der Kontaktwerkstoff **6** befestigt wird, zum Beispiel durch Festklemmen an den Stirnseiten des Kernes **1**.

Werden die Kontaktwalzen **9,10** innerhalb des Galvanisierelektrolyten verwendet, sind entsprechende, in **Fig. 1a** bis **1c** nicht dargestellte Abschirmungen, zum Beispiel Abschirmhauben erforderlich, um einen Metallniederschlag auf dem elastischen Kontaktwerkstoff **2,5,6** zu vermeiden oder zumindest gering zu halten.

### Bezugszeichenliste

- **1**: Walzenkern
- **2**: Elastischer leitfähiger Kontaktwerkstoff
- **3**: Walzenlager
- **4**: Kontaktierung zur Stromübertragung
- **5**: Ringförmig geformter Kontaktwerkstoff
- **6**: Spiralförmiger Kontaktwerkstoff
- **7**: Behandlungsgut
- **8**: Lagerzapfen
- **9**: Untere Kontaktwalze
- **10**: Obere Kontaktwalze

## Patentansprüche

1. Durchlaufbehandlungsanlage zur elektrolytischen Behandlung von in einer Transportebene geführtem flachem Behandlungsgut mit mindestens einem eine Kontaktkraft auf das Behandlungsgut ausübenden Rotationselement für die elektrische Kontaktierung des Behandlungsgutes, **dadurch gekennzeichnet, dass** das mindestens eine Rotationselement (**9,10**) an dessen auf dem Behandlungsgut (**7**) abrollender Lauffläche zumindest teilweise mit einem elastischen, elektrisch leitfähigen Werkstoff (**2,5,6**) versehen ist, dass mindestens ein Rotationselement (**9,10**) an einer ersten Seite der Transportebene angeordnet ist und dass mindestens eine nichtleitende Stützwalze oder mindestens ein nichtleitendes Stützrad oder mindestens ein Rotationselement (**9,10**) an einer zweiten Seite der Transportebene so angeordnet ist, dass diese/s die Gegenkraft des mindestens einen Rotationselements (**9,10**) an der ersten Seite aufnimmt.

2. Durchlaufbehandlungsanlage nach Anspruch 1, **dadurch gekennzeichnet, dass** das Rotationselement (**9,10**) als Kontaktwalze ausgebildet ist.

3. Durchlaufbehandlungsanlage nach Anspruch 1, **dadurch gekennzeichnet, dass** das Rotationselement (**9,10**) als Kontaktrad ausgebildet ist.

4. Durchlaufbehandlungsanlage nach Anspruch 1, **dadurch gekennzeichnet, dass** das Rotationselement (**9,10**) als Kontaktspirale ausgebildet ist.

5. Durchlaufbehandlungsanlage nach einem der vorstehenden Ansprüche, **dadurch gekennzeichnet, dass** das Rotationselement (**9,10**) zum Transport des plattenförmigen Gutes (**7**) mit einem Antrieb versehen ist.

6. Durchlaufbehandlungsanlage nach einem der vorstehenden Ansprüche, **dadurch gekennzeichnet, dass** das als Kontaktwalze ausgebildete Rotationselement (**9,10**) einen elektrisch leitfähigen Kern (**1**) aufweist.

7. Durchlaufbehandlungsanlage nach Anspruch 6, **dadurch gekennzeichnet, dass** der elektrisch leitfähige Kern (**1**) eine aus Metall bestehende Oberfläche aufweist.

8. Durchlaufbehandlungsanlage nach einem der Ansprüche 6 und 7, **dadurch gekennzeichnet, dass** der elektrisch leitfähige Kern (**1**) zumindest überwiegend mit dem elastischen, elektrisch leitfähigen Werkstoff (**2**) überzogen ist.

9. Durchlaufbehandlungsanlage nach einem der Ansprüche 6 bis 8, **dadurch gekennzeichnet, dass** auf den nicht mit dem elastischen, elektrisch leitfähigen Werkstoff (**5,6**) versehenen Kernoberflächen ein elektrisch nichtleitender Überzug aufgebracht ist, zumindest soweit die Flächen mit Behandlungsflüssigkeit in Berührung kommen können.

10. Durchlaufbehandlungsanlage nach einem der Ansprüche 6 bis 9, **dadurch gekennzeichnet, dass** der elektrisch leitfähige Kern (**1**) an der Mantelfläche mindestens eine Rille mit jeweils einem formschlüssig eingelegten, über die Mantelfläche des Kerns (**1**) hinausragenden, elastischen, elektrisch leitfähigen Kontaktstreifen (**5,6**) aufweist.

11. Durchlaufbehandlungsanlage nach Anspruch 10, **dadurch gekennzeichnet, dass** der mindestens eine Kontaktstreifen (**5**) ringförmig an der Mantelfläche verläuft.

12. Durchlaufbehandlungsanlage nach Anspruch 10, **dadurch gekennzeichnet, dass** der mindestens eine Kontaktstreifen (**6**) spiralförmig an der Mantelfläche verläuft.

13. Durchlaufbehandlungsanlage nach Anspruch 12, **dadurch gekennzeichnet, dass** der Kontaktstreifen (**6**) an den Enden der Kontaktwalze (**9,10**) befestigt ist.

14. Durchlaufbehandlungsanlage nach einem der vorstehenden Ansprüche, **dadurch gekennzeichnet, dass** mindestens ein Schleifkontakt (**4**) zur Stromversorgung des Rotationselements (**9,10**) vorgesehen ist.

15. Durchlaufbehandlungsanlage nach einem der Ansprüche 1 bis 13, **dadurch gekennzeichnet, dass** mindestens ein ein fliessfähiges Stromübertragungsmittel enthaltender Drehkontakt (**4**) zur Stromversorgung des Rotationselements (**9,10**) vorgesehen ist.

16. Durchlaufbehandlungsanlage nach einem der vorstehenden Ansprüche, **dadurch gekennzeichnet, dass** mindestens zwei Rotationselemente (**9,10**) zur elektrischen Kontaktierung des Behandlungsgutes (**7**) vorgesehen sind und dass die Rotationselemente (**9,10**) an deren auf dem Behandlungsgut (**7**) abrollender Lauffläche zumindest teilweise mit einem elastischen, elektrisch leitfähigen Werkstoff (**2,5,6**) versehen sind, wobei die Rotationselemente (**9,10**) in Durchlaufrichtung gesehen in der Durchlaufbehandlungsanlage hintereinander angeordnet sind und die Härte des elastischen, elektrisch leitfähigen Werkstoffes (**2,5,6**) an den einzelnen Rotationselementen (**9,10**) in Durchlaufrichtung zunimmt.

17. Durchlaufbehandlungsanlage nach einem der vorstehenden Ansprüche, **dadurch gekennzeichnet, dass** mindestens zwei Rotationselemente (**9,10**) zur elektrischen Kontaktierung des Behandlungsgutes (**7**) vorgesehen sind und dass die Rotationselemente (**9,10**) an deren auf dem Behandlungsgut (**7**) abrollender Lauffläche zumindest teilweise mit einem elastischen, elektrisch leitfähigen Werkstoff (**2,5,6**) versehen sind, wobei die Rotationselemente (**9,10**) in der eine Transportebene für das Behandlungsgut (**7**) aufweisenden Durchlaufbehandlungsanlage beiderseits der Transportebene angeordnet sind.

## Claims

1. Continuous treatment plant for electrolytic treatment of a flat item to be treated which is guided in a transport plane, having at least one rotational element, which exerts a contact force on the item to be treated, for the electrical contacting of the item to be treated, **characterised in that** the at least one rotational element (**9, 10**), on its running face which runs on the item to be treated (**7**), is provided at least partly with an elastic, electrically conductive material (**2, 5, 6**), **in that** at least one rotational element (**9, 10**) is disposed on a first side of the transport plane, and **in that** at least one non-conductive support roller or at least one non-conductive support wheel or at least one rotational element (**9, 10**) is disposed on a second side of the transport plane such that this/these take up the counter-force of the at least one rotational element (**9, 10**) on the first side.

2. Continuous treatment plant according to claim 1, **characterised in that** the rotational element (**9, 10**) is configured as a contact roller.

3. Continuous treatment plant according to claim 1, **characterised in that** the rotational element (**9, 10**) is configured as a contact wheel.

4. Continuous treatment plant according to claim 1, **characterised in that** the rotational element (**9, 10**) is configured as a contact spiral.

5. Continuous treatment plant according to one of the preceding claims, **characterised in that** the rotational element (**9, 10**) is provided with a drive for transporting the plate-shaped item (**7**).

6. Continuous treatment plant according to one of the preceding claims, **characterised in that** the rotational element (**9, 10**), which is configured as contact roller, has an electrically conductive core (**1**).

7. Continuous treatment plant according to claim 6, **characterised in that** the electrically conductive core (**1**) has a surface formed from metal.

8. Continuous treatment plant according to one of the claims 6 and 7, **characterised in that** the electrically conductive core (**1**) is covered at least predominantly with the elastic, electrically conductive material (**2**).

9. Continuous treatment plant according to one of the claims 6 to 8, **characterised in that**, on the core surfaces not provided with the elastic, electrically conductive material (**5, 6**), an electrically non-conductive covering is applied, at least in so far as the faces can come into contact with treatment fluid.

10. Continuous treatment plant according to one of the claims 6 to 9, **characterised in that** the electrically conductive core (**1**) on the outer peripheral face has at least one groove with respectively one elastic, electrically conductive contact strip (**5, 6**), which is inserted in a form-fitting manner and protrudes beyond the outer peripheral face of the core (**1**).

11. Continuous treatment plant according to claim 10, **characterised in that** the at least one contact strip (**5**) extends annularly on the outer peripheral face.

12. Continuous treatment plant according to claim 10, **characterised in that** the at least one contact strip (**6**) extends helically on the outer peripheral face.

13. Continuous treatment plant according to claim 12, **characterised in that** the contact strip (**6**) is attached to the ends of the contact roller (**9, 10**).

14. Continuous treatment plant according to one of the preceding claims, **characterised in that** at least one sliding contact (**4**) is provided for current supply of the rotational element (**9, 10**).

15. Continuous treatment plant according to one of the claims 1 to 13, **characterised in that** at least one rotary contact (**4**) containing a flowable current transmission means is provided for current supply of the rotational element (**9, 10**).

16. Continuous treatment plant according to one of the preceding claims, **characterised in that** at least two rotational elements (**9, 10**) are provided for electrical contacting of the item to be treated (**7**), and **in that** the rotational elements (**9, 10**), on their running face which runs on the item to be treated (**7**), are provided at least partly with an elastic, electrically conductive material (**2, 5, 6**), the rotational elements (**9, 10**), as observed in the through-flow direction, being disposed one behind the other in the continuous treatment plant and the hardness of the elastic, electrically conductive material (**2, 5, 6**) on the individual rotational elements (**9, 10**) increases in the through-flow direction.

17. Continuous treatment plant according to one of the preceding claims, **characterised in that** at least two rotational elements (**9, 10**) are provided for electrical contacting of the item to be treated (**7**), and **in that** the rotational elements (**9, 10**), on their running face which runs on the item to be treated (**7**), are provided at least partly with an elastic, electrically conductive material (**2, 5, 6**), the rotational elements (**9, 10**) in the continuous treatment plant, which has a transport plane for the item to be treated (**7**), are disposed on both sides of the transport plane.

## Revendications

1. Installation de traitement en continu pour le traitement électrolytique d'un produit à traiter plat guidé dans un plan de transport avec au moins un élément de rotation pour l'établissement d'un contact électrique avec le produit à traiter qui exerce une force de contact sur le produit à traiter, **caractérisée en ce que** l'au moins un élément de rotation (9, 10) est muni sur sa surface de roulement se déroulant sur le produit à traiter (7) au moins partiellement d'un matériau souple et électroconducteur (2, 5, 6), **en ce qu'**au moins un élément de rotation (9, 10) est disposé sur un premier côté du plan de transport et **en ce qu'**au moins un tambour de soutien non-conducteur ou au moins une roue de soutien non-conductrice ou au moins un élément de rotation (9, 10) est disposé de telle façon sur un deuxième côté du plan de transport que celui-ci ou celle-ci absorbe sur le premier côté la force opposée de l'au moins un élément de rotation (9, 10).

2. Installation de traitement en continu selon la revendication 1, **caractérisée en ce que** l'élément de rotation (9, 10) est configuré comme tambour de contact.

3. Installation de traitement en continu selon la revendication 1, **caractérisée en ce que** l'élément de rotation (9, 10) est configuré comme roue de contact.

4. Installation de traitement en continu selon la revendication 1, **caractérisée en ce que** l'élément de rotation (9, 10) est configuré comme spirale de contact.

5. Installation de traitement en continu selon l'une quelconque des revendications précédentes, **caractérisée en ce que** l'élément de rotation (9, 10) est muni d'un moteur d'entraînement pour le transport du produit en forme de plaque (7).

6. Installation de traitement en continu selon l'une quelconque des revendications précédentes, **caractérisée en ce que** l'élément de rotation (9, 10) configuré comme tambour de contact comprend un noyau (1) électroconducteur.

7. Installation de traitement en continu selon la revendication 6, **caractérisée en ce que** le noyau (1) électroconducteur est muni d'une surface se composant de métal.

8. Installation de traitement en continu selon l'une quelconque des revendications 6 et 7, **caractérisée en ce que** le noyau (1) électroconducteur est revêtu au moins de manière prépondérante du matériau souple et électroconducteur (2).

9. Installation de traitement en continu selon l'une quelconque des revendications 6 à 8, **caractérisée en ce que** sur les surfaces du noyau non revêtues du matériau souple et électroconducteur (5, 6) est placé un revêtement non électroconducteur, et ceci au moins dans la mesure où les surfaces peuvent arriver au contact avec du liquide de traitement.

10. Installation de traitement en continu selon l'une quelconque des revendications 6 à 9, **caractérisée en ce que** le noyau (1) électroconducteur comprend sur la surface d'enveloppe au moins une rainure avec respectivement une bande de contact (5, 6) souple, électroconductrice, placée en solidarité de forme et dépassant au-delà de la surface d'enveloppe du noyau (1).

11. Installation de traitement en continu selon la revendication 10, **caractérisée en ce que** l'au moins une bande de contact (5) s'étend en forme d'anneau sur la surface d'enveloppe.

12. Installation de traitement en continu selon la revendication 10, **caractérisée en ce que** l'au moins une bande de contact (6) s'étend en forme de spirale sur la surface d'enveloppe.

13. Installation de traitement en continu selon la revendication 12, **caractérisée en ce que** la bande de contact (6) est fixée sur les extrémités du tambour de contact (9, 10).

14. Installation de traitement en continu selon l'une quelconque des revendications précédentes, **caractérisée en ce qu'**au moins un contact à friction (4) est prévu pour l'alimentation électrique de l'élément de rotation (9, 10).

15. Installation de traitement en continu selon l'une quelconque des revendications 1 à 13, **caractérisée en ce qu'**au moins un contact tournant (4) comprenant un moyen de transmission de courant capable de subir un fluage est prévu pour l'alimentation électrique de l'élément de rotation (9, 10).

16. Installation de traitement en continu selon l'une quelconque des revendications précédentes, **caractérisée en ce qu'**au moins deux éléments de rotation (9, 10) sont prévus pour assurer le contact électrique avec le produit à traiter (7) et **en ce que** les éléments de rotation (9, 10) sont munis sur leur surface de roulement se déroulant sur le produit à traiter (7) au moins partiellement d'un matériau souple et électroconducteur (2, 5, 6), les éléments de rotation (9, 10) étant, en regardant dans la direction du passage, disposés les uns derrière les autres dans l'installation de traitement en continu et la dureté du matériau souple et électroconducteur (2, 5, 6) augmentant dans la direction du passage aux différents éléments de rotation (9, 10).

17. Installation de traitement en continu selon l'une quelconque des revendications précédentes, **caractérisée en ce qu'**au moins deux éléments de rotation (9, 10) sont prévus pour assurer le contact électrique avec le produit à traiter (7) et **en ce que** les éléments de rotation (9, 10) sont munis sur leur surface de roulement se déroulant sur le produit à traiter (7) au moins partiellement d'un matériau souple et électroconducteur (2, 5, 6), les éléments de rotation (9, 10) étant disposés des deux côtés du plan de transport dans l'installation de traitement en continu comprenant un plan de transport pour le produit à traiter (7).
